# EUROPÄISCHE PATENTSCHRIFT

(11) **EP 4 273 566 B1**
(45) Veröffentlichungstag und Bekanntmachung des Hinweises auf die Patenterteilung: **24.12.2025**
(21) Anmeldenummer: 22171379.5
(22) Anmeldetag: 03.05.2022
(51) Int. Cl.: G01R 31/54, B60R 21/017

(54) **ELEKTRISCHE ANORDNUNG MIT EINEM REDUNDANTEN ELEKTRISCHEN ÜBERTRAGUNGSWEG UND MITTEL ZUR ERKENNUNG EINES FEHLERZUSTANDES DESSELBEN SOWIE VERFAHREN ZUR ERKENNUNG EINES FEHLERZUSTANDES DES REDUNDANTEN ELEKTRISCHEN ÜBERTRAGUNGSWEGES DER ELEKTRISCHEN ANORDNUNG**
ELECTRICAL ARRANGEMENT COMPRISING A REDUNDANT ELECTRICAL TRANSMISSION PATH AND MEANS FOR DETECTING AN ERROR STATE THEREOF AND METHOD FOR DETECTING AN ERROR STATE OF THE REDUNDANT ELECTRICAL TRANSMISSION PATH OF THE ELECTRICAL ARRANGEMENT
AGENCEMENT ÉLECTRIQUE DOTÉ D'UN CHEMIN DE TRANSMISSION ÉLECTRIQUE REDONDANT ET MOYEN DE DÉTECTION D'UN ÉTAT DE DÉFAILLANCE DE CELUI-CI, AINSI QUE PROCÉDÉ DE DÉTECTION D'UN ÉTAT DE DÉFAILLANCE DU CHEMIN DE TRANSMISSION ÉLECTRIQUE REDONDANT DE L'AGENCEMENT ÉLECTRIQUE

(43) Veröffentlichungstag der Anmeldung: 08.11.2023
(73) Patentinhaber: IMS Gear SE & Co. KGaA, 78166 Donaueschingen (DE)
(72) Erfinder: Rehle, Daniel, 78078 Niedereschach (DE)
(74) Vertreter: Westphal, Mussgnug & Partner Patentanwälte mbB

(56) Entgegenhaltungen:
- EP-A1- 2 720 047
- DE-A1- 102013 203 921
- DE-A1- 102019 217 083
- DE-A1- 3 221 176

## Beschreibung

Die Erfindung betrifft eine elektrische Anordnung mit einem redundanten elektrischen Übertragungsweg und Mittel zur Erkennung eines Defektes des redundanten elektrischen Übertragungsweg sowie Verfahren zur Erkennung eines Defektes des redundanten elektrischen Übertragungsweges.

Eine solche Anordnung ist z. B. aus DE 10 2019 217 083 A1 bekannt.

Bei sicherheitskritischen Komponenten muss sichergestellt werden, dass deren Stromzuführungen nicht durch Leitungsbruch, fehlerhafte Steckverbindungen oder Korrosion unterbrochen werden. Dies gilt auch für sicherheitskritische Funktionen, die bspw. über ein Stromsignal ausgelöst werden. Ein Beispiel hierfür ist die Stromzuführung für Airbags in Fahrzeugen oder die Auslösung derselben mittels eines über eine Steuerleitung zugeführten Stromsignals.

Es ist bekannt, für solche Fälle die elektrischen Verbindungen redundant mit zwei parallel geführten elektrischen Leitungen auszuführen und diesen elektrischen redundanten Übertragungsweg so zu überwachen, dass bereits der Ausfall einer der beiden elektrischen Leitungen erkannt wird.

Aus der EP 0 953 154 A1 ist eine Vorrichtung und ein Verfahren zur Detektion von Leiterbahnunterbrechungen bei Solarmodulen bekannt. Bei aus einzelnen über Leiterbahnen miteinander verbundenen Solarzellen aufgebauten Solarmodulen kann es zu Unterbrechungen in den Leiterbahnen kommen, die zu einer Unbrauchbarkeit des Solarmoduls führen können. Zur Detektion einer solchen Leiterbahnunterbrechung wird vorgeschlagen, eine Induktivität an eine zwischen zwei benachbarten Solarzellen des Solarmoduls ausgebildeten Leiterschleife anzukoppeln. Die Induktivität bildet zusammen mit einer Kapazität einen Schwingkreis, welcher mittels eines Wechselspannungsgenerators angeregt wird. Die von dem Scheinwiderstand der Leiterschleife abhängige Änderung der Oszillatoreigenschaften des Resonanzkreises wird mittels eines an den Resonanzkreis gekoppelten Messwandlers erfasst. Damit werden die durch eine Leiterbahnunterbrechung hervorgerufenen Änderungen von Kenngrößen des Resonanzkreises mittels des Messwertwandlers angezeigt.

Weitere elektrische Anordnungen zur Fehlererkennung sind in DE 32 21 176 A1 und DE 10 2013 203 921 A1 beschrieben.

Es ist die Aufgabe der Erfindung, eine elektrische Anordnung mit einem redundanten elektrischen Übertragungsweg und einfachen Mitteln zur Erkennung eines Defektes bzw. Fehlerzustandes des redundanten elektrischen Übertragungsweg bereitzustellen. Ferner ist es Aufgabe der Erfindung ein Verfahren zur Erkennung eines Defektes bzw. eines Fehlerzustandes des redundanten elektrischen Übertragungsweges der Anordnung anzugeben.

Die erstgenannte Aufgabe wird gelöst durch eine elektrische Anordnung mit den Merkmalen des Patentanspruchs 1.

Hiernach wird eine elektrische Anordnung mit einer ersten elektrischen Vorrichtung, einer zweiten elektrischen Vorrichtung, einem redundanten elektrischen Übertragungsweg mit zwei parallel geschalteten elektrischen Verbindungsleitungen zwischen der ersten elektrischen Vorrichtung und der zweiten elektrischen Vorrichtung, und Mitteln zur Erkennung eines Fehlerzustandes des redundanten elektrischen Übertragungsweges vorgeschlagen. Die Mittel umfassen einen Magnetkern mit einem Primärleiter mit wenigstens einer halben Wicklungsschleife bis zu drei Wicklungsschleifen, die nur von einer der beiden Verbindungsleitungen gebildet ist, und mit einer Sekundärwicklung mit einer Windungszahl größer als die Anzahl der Wicklungsschleifen des Primärleiters. Dabei sind der Primärleiter und die Sekundärwicklung über den Magnetkern stark induktiv gekoppelt. Ferner umfassen die Mittel eine Diagnosevorrichtung zur Auswertung eines induktivitätsabhängigen Messsignals der Sekundärwicklung, wobei die Diagnosevorrichtung ausgebildet ist, die induktivitätsabhängigen Messsignale (L_{M}) der Sekundärwicklung mit einem zur Unterscheidung zwischen einem Fehlerzustand und einem Nicht-Fehlerzustand des redundanten elektrischen Übertragungsweges verwendbaren Fehlerschwellwert zu vergleichen.

Diese elektrische Anordnung weist damit äußerst wenige und zudem einfache Mittel zur induktiven Detektion eines Fehlerzustandes, wie bspw. bei einem durch einen Leitungsbruch ausgelösten Ausfalls einer der beiden elektrischen Verbindungsleitungen des redundanten elektrischen Übertragungsweges auf. Als Mittel wird ein Magnetkern mit einem Primärleiter eingesetzt, welcher von einer der beiden Verbindungsleitungen gebildet wird. Eine Sekundärwicklung des Magnetkerns wird mit dem Primärleiter induktiv gekoppelt, wobei der Primärleiter nur wenige Wicklungsschleifen aufweist und im einfachsten Fall ein gerades Teilstück der Verbindungsleitung ist, also lediglich eine halbe Wicklungsschleife darstellt.

Mit diesen Mitteln wird das Prinzip der Impedanztransformation genutzt, wobei vorzugsweise der Primärleiter sehr niederohmig ausführbar ist und infolgedessen der von dem Magnetkern zusammen mit dem Primärleiter und der Sekundärwicklung gebildete Transformator zu keinen nachteiligen Folgen in dem elektrischen Übertragungsweg für die Funktion der elektrischen Anordnungen zur Folge hat.

Ein weiterer Vorteil besteht darin, dass zur Erkennung eines Fehlerzustandes, also eines Defektes des redundanten elektrischen Übertragungsweges die beiden Verbindungsleitungen nicht notwendigerweise bestromt werden müssen.

Die Erzeugung des induktivitätsabhängigen Messsignals kann in unterschiedlicher Weise realisiert werden, die dem Fachmann bekannt sind.

Besonders vorteilhaft ist es, wenn der Primärleiter wenige Wicklungsschleifen aufweist, damit der Weg über den Primärleiter und die Sekundärwicklung auch im Fehlerfall, also bei Vorliegen des Fehlerzustandes möglichst wenig beeinflusst wird.

Die Windungszahl der Sekundärwicklung ist größer als die Anzahl der Wicklungsschleifen des Primärleiters. Die höhere Windungszahl der Sekundärwicklung vermindert den Einfluss des induktivitätsabhängigen Messsignals auf die Primärwicklung und die Sekundärwicklung und führt zu einem Messsignal mit gutem Rauschabstand an der Sekundärwicklung, welches leicht zu messen ist.

Die elektrischen Verbindungsleitungen des redundanten elektrischen Übertragungsweges sind als Versorgungsleitungen zur Energieversorgung oder als Signalleitungen ausgebildet. Auch können die elektrischen Verbindungsleitungen als Schaltkontakte oder als Steck- bzw. Schleifenkontakte ausgebildet sein. Die zweitgenannte Aufgabe wird gelöst durch ein Verfahren mit den Merkmalen des Patentanspruchs 6.

Dieses Verfahren zur Erkennung eines Fehlerzustandes eines redundanten elektrischen Übertragungsweges mit zwei parallel geschalteten elektrischen Verbindungsleitungen zwischen einer ersten elektrischen Vorrichtung und einer zweiten elektrischen Vorrichtung sowie einer Messinduktivität, welche mit wenigstens einer von einer der beiden Verbindungsleitungen gebildeten halben Wicklungsschleife induktiv gekoppelt ist, umfasst nach der erstgenannten Lösung die Verfahrensschritte:
- Erzeugen eines induktivitätsabhängigen Messsignals der Messinduktivität,
- Auswerten des induktivitätsabhängigen Messsignals zur Unterscheidung eines Fehlerzustandes von einem Nicht-Fehlerzustand des redundanten elektrischen Übertragungsweges, indem das induktivitätsabhängige Messsignal der Messinduktivität mit einem zur Unterscheidung zwischen einem Fehlerzustand und einem Nicht-Fehlerzustand des redundanten elektrischen Übertragungsweges verwendbaren Vergleichswert, insbesondere einem Fehlerschwellwert, verglichen wird,
- Anzeigen, dass ein Nicht-Fehlerzustand vorliegt, wenn das induktivitätsabhängige Messsignal kleiner als der Vergleichswert ist, und
- Anzeigen, dass bei einer der Verbindungsleitungen (L1, L2) ein Fehlerzustand vorliegt, wenn das induktivitätsabhängige Messsignal (L_{M}) größer als der Vergleichswert, also insbesondere der Fehlerschwellwert ist.

Wenngleich es in den meisten Anwendungsfällen ausreicht, als Vergleichswert einen Fehlerschwellwert festzulegen, also einen vorgegebenen konstanten Wert zu definieren, bei dessen Überschreitung ein Fehler detektiert wird, liegt es auch im Rahmen der vorliegenden Erfindung anstelle eines festen Schwellwertes den Grad der zeitlichen Veränderung des Messsignals als Maß für die Fehlerdetektion heranzuziehen. Ändert sich das Signal von einer zur anderen Messung zu schnell, kann dies ebenfalls auf einen Fehler hindeuten, was erfindungsgemäß detektiert werden kann.. Hierdurch kann vorteilhafterweise eine schleichende, also allmähliche Verschlechterung des redundanten Übertragungsweges erkannt werden. Damit kann eine Art eines Condition Monitoring des redundanten Übertragungsweges durchgeführt werden.

Das erfindungsgemäße Verfahren ist mit geringen Mitteln einfach durchführbar. Zunächst wird ein induktivitätsabhängiges Messsignal einer Messinduktivität erzeugt, wobei diese Messinduktivität eine Sekundärwicklung ist, die mittels eines Magnetkernes mit wenigstens einer von einer der beiden Verbindungsleitungen gebildeten Wicklungsschleife als Primärleiter induktiv gekoppelt ist. Das induktivitätsabhängige Messsignal der Messinduktivität wird hinsichtlich des Vorliegens oder des Nichtvorliegens eines Fehlerzustandes des redundanten elektrischen Übertragungsweges ausgewertet. Hierzu ist der Vergleichswert, insbesondere der Fehlerschwellwert an die Art der Erzeugung des induktivitätsabhängigen Messsignals angepasst, so dass er geeignet ist durch einen Vergleich mit dem induktivitätsabhängigen Messsignal einen Defekt, also bspw. einen Leitungsbruch als Fehlerzustand des elektrischen Übertragungsweges zu erkennen.

Die Erzeugung des induktivitätsabhängigen Messsignal kann in unterschiedlicher Weise realisiert werden, die dem Fachmann bekannt sind.

So kann bspw. an die Sekundärwicklung eine Wechselspannung angelegt werden und aus dem dadurch erzeugten Wechselstrom als induktivitätsabhängiges Messsignal die Reaktanz als Vergleichswert für den Vergleich mit dem Fehlerschwellwert bestimmt werden. Der Vergleichswert oder Fehlerschwellwert wird derart bestimmt, dass bei einem Nicht-Fehlerzustand der Vergleichswert kleiner als dieser Fehlerschwellwert ist und bei einem Fehlerzustand, also bspw. einem Leitungsbruch einer der beiden Leitungen des redundanten Übertragungsweges, der Vergleichswert größer als dieser Fehlerschwellwert ist.

Damit zeigt eine niedrige Reaktanz an, dass die beiden Leitungen in Ordnung sind, also eine Redundanz des elektrischen Übertragungsweges vorhanden ist. Im Falle einer hohen Reaktanz wird dagegen ein Ausfall, d. h. ein Leitungsbruch einer der beiden Verbindungsleitungen angezeigt, somit ist eine Redundanz des elektrischen Übertragungsweges in diesem Fall nicht vorhanden.

Ein anderes weiterbildungsgemäßes Verfahren zur Erzeugung des induktivitätsabhängigen Messsignals besteht darin, das Dämpfungsverhalten eines mit der Sekundärwicklung aufgebauten Tief- oder Hochpasses, also z.B. eine RL- oder LC-Filtereinrichtung zu bestimmen. Aus dem das Dämpfungsverhalten anzeigenden induktivitätsabhängigen Messsignal wird ein Dämpfungswert als Vergleichswert ermittelt und mit einem entsprechend geeigneten Fehlerschwellwert verglichen.

Nach einer weiteren Ausgestaltung der Erfindung ist es möglich mit der Sekundärwicklung einen LC-Resonanzkreis aufzubauen, so dass dessen Resonanzverhalten mit dem induktivitätsabhängigen Messsignal angezeigt wird und hieraus als Vergleichswert die Resonanzfrequenz ermittelt wird, um mit einem entsprechend geeigneten Fehlerschwellwert verglichen zu werden.

Schließlich können auch weiterbildungsgemäß mittels des induktivitätsabhängigen Messsignals Signalverformungen eines an die Sekundärwicklung angelegten Steuersignals mit mehreren Frequenzkomponenten erfasst und ausgewertet werden. Insbesondere kann hierzu der Zeitverlauf beim Ein- und/oder Ausschalten der Sekundärwicklung erfasst und hinsichtlich der Einschwingvorgänge und/oder aus Ausschwingvorgänge ausgewertet werden.

Die Erfindung wird nachfolgend anhand von Ausführungsbeispielen unter Bezugnahme auf die beigefügten Figuren ausführlich beschrieben. Es zeigen:
- Figur 1:: ein Schaltbild einer elektrischen Anordnung gemäß der Erfindung,
- Figur 2: eine schematische Detaildarstellung des Magnetkernes MK nach Figur 1, und
- Figur 3: ein Schaltbild einer weiteren elektrischen Anordnung gemäß der Erfindung.

Wenngleich in den nachfolgenden Figuren und der zugehörenden Beschreibung stets von einem Fehlerschwellwert die Rede ist, kann - wie einleitend erläutert ist - anstelle eines Fehlerschwellwertes auch der Grad der zeitlichen Änderung des Messsignals zur Fehlerdetektion herangezogen werden, um beispielsweise schleichende Veränderungen des redundanten Übertragungsweges zu erfassen.

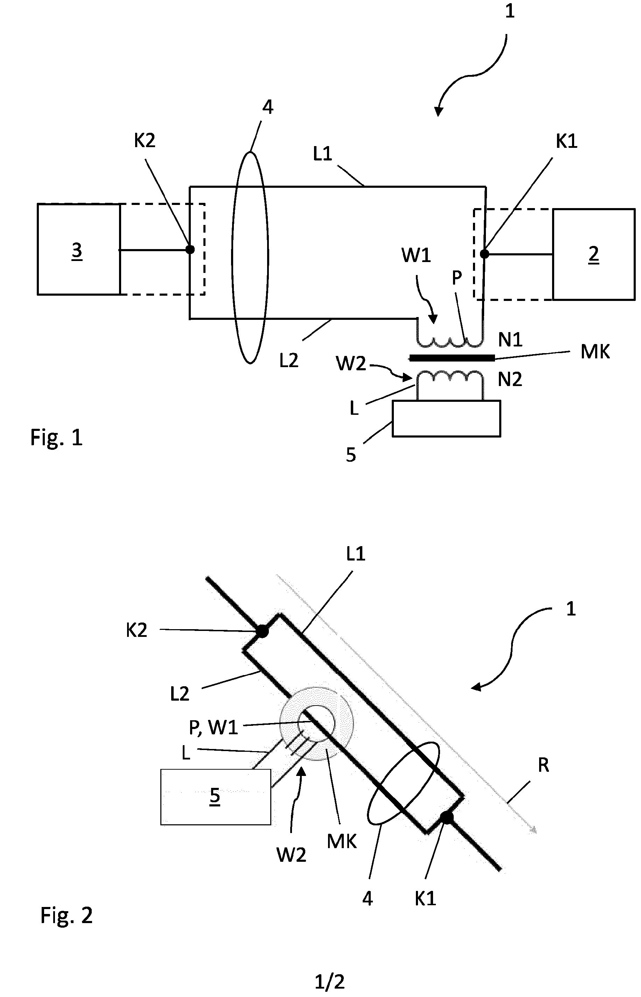

Die elektrische Anordnung 1 gemäß Figur 1 umfasst eine erste elektrische Vorrichtung 2 sowie eine zweite elektrische Vorrichtung 3, die mittels eines redundanten elektrischen Übertragungsweges 4 elektrisch miteinander verbunden sind. Dieser elektrische Übertragungsweg 4 besteht aus zwei elektrischen Verbindungsleitungen L1 und L2, die über Knotenpunkte K1 und K2 parallel geschaltet sind.

Die erste elektrische Vorrichtung 2 ist mit dem Knotenpunkt K1 elektrisch verbunden, so dass dieser Knotenpunkt K1 außerhalb der ersten elektrischen Vorrichtung 2 liegt. Es ist auch möglich, dass dieser Knotenpunkt K1 innerhalb der ersten elektrischen Vorrichtung 2 liegt (gestrichelte Darstellung der ersten elektrischen Vorrichtung 2).

Die zweite elektrische Vorrichtung 3 ist mit dem Knotenpunkt K2 elektrisch verbunden, so dass dieser Knotenpunkt K2 außerhalb der zweiten elektrischen Vorrichtung 3 liegt. Es ist auch möglich, dass dieser Knotenpunkt K2 innerhalb der zweiten elektrischen Vorrichtung 3 liegt (gestrichelte Darstellung der zweiten elektrischen Vorrichtung 3).

Beispielsweise ist die erste elektrische Vorrichtung 2 eine Airbag-Steuereinheit und die zweite elektrische Vorrichtung 3 ein Airbagmodul, welches über die beiden Verbindungsleitungen L1 und L2 des redundanten elektrischen Übertragungswegs 4 mit elektrischer Energie oder mit einem Stromsignal als Auslösesignal versorgt wird. Im erstgenannten Fall stellen die beiden Verbindungsleitungen L1 und L2 Stromversorgungsleitungen und im zweitgenannten Fall Signalleitungen dar.

Die elektrische Anordnung 1 weist Mittel auf, mit welchen ein Defekt, bspw. ein Leitungsbruch einer der beiden Verbindungsleitungen L1 oder L2 erkannt bzw. detektiert wird. Mit diesen Mitteln wird ein Fehlerzustand, d. h. ein Defekt, oder ein Nicht-Fehlerzustand des elektrischen Übertragungswegs 4 detektiert.

Diese Mittel umfassen einen Magnetkern MK, welcher einen Primärleiter P mit wenigstens einer halben Wicklungsschleife W1 und eine Sekundärwicklung W2 aufweist. Der Primärleiter P wird von der Verbindungsleitung L2 gebildet und weist nur wenige Wicklungsschleifen W1, bspw. drei (N1 = 3) Wicklungsschleifen W1 auf, während die Windungszahl N2 der Sekundärwicklung W2 größer ist als die Anzahl N1 der Wicklungsschleifen W1. Wenn also die Anzahl N1=3 ist, beträgt die Windungszahl N2 der Sekundärwicklung W2 bspw. 30.

Die Sekundärwicklung W2 ist über den Magnetkern MK mit dem Primärleiter P induktiv stark gekoppelt, infolgedessen die Induktivität der Sekundärwicklung W2 vom Zustand des elektrischen Übertragungsweges 4 abhängt, d. h. ob ein Defekt, also ein Leitungsbruch der elektrischen Verbindungsleitung L1 und/oder der elektrischen Verbindungsleitung L2 vorliegt. Daher wird die Sekundärwicklung W2 auch als Messinduktivität L bezeichnet. Die Kopplung der Sekundärwicklung W2 mit dem Primärleiter P hängt von der Geometrie und dem Material des Magnetkernes MK und von der Anordnung des Primärleiters P und der Sekundärwicklung W2 ab.

Der Primärleiter weist nur wenige Wicklungsschleifen W1 auf, im einfachsten Fall besteht der Primärleiter P lediglich aus einem geraden Teilstück der Verbindungsleitung L2. Damit wird sichergestellt, dass der Primärleiter P niederohmig ist, d. h. befindet sich im Bereich von 100 mΩ oder darunter, infolgedessen der von dem Magnetkern MK zusammen mit dem Primärleiter P und der Sekundärwicklung W2 gebildete Transformator keinen negativen Einfluss auf die Funktion der elektrischen Anordnung 1 hat, insbesondere weil die Schleifenimpedanz des Primärleiters P im fehlerfreien Fall des elektrischen Übertragungsweges 4, wenn also kein Defekt vorliegt, sehr klein bleibt.

Als weiteres Mittel zur Detektion eines Defektes, bspw. eines Leitungsbruchs einer der beiden Verbindungsleitungen L1 oder L2, ist eine Diagnosevorrichtung 5 vorgesehen, die an die Sekundärwicklung W2 als Messinduktivität L angeschlossen ist und mit welcher ein von der Messinduktivität L erzeugtes induktivitätsabhängiges Messsignal L_{M} zur Unterscheidung zwischen einem Fehlerzustand und einem Nicht-Fehlerzustand des redundanten elektrischen Übertragungsweges 4 ausgewertet wird. Hierzu wird das induktivitätsabhängige Messsignal L_{M} mit einem Fehlerschwellwert verglichen.

Liegt kein Defekt, also der Nicht-Fehlerzustand der beiden elektrischen Verbindungsleitungen L1 und L2 vor, ist also die Redundanz des Übertragungsweges 4 vorhanden, zeigt das induktivitätsabhängige Messsignal L_{M} eine niedrige Induktivität an, die also kleiner als der Fehlerschwellwert ist.

Weist dagegen einer der beiden elektrischen Verbindungsleitungen L1 und L2 einen Defekt, insbesondere einen Leitungsbruch als Fehlerzustand auf, ist also die Redundanz des Übertragungsweges 4 nicht vorhanden, wird eine hohe Induktivität durch das induktivitätsabhängige Messsignal L_{M} angezeigt, die also größer als der Fehlerschwellwert ist.

Für die Erzeugung des induktivitätsabhängigen Messsignals L_{M} gibt es verschiedene Verfahren.

Eine erste Möglichkeit zur Erzeugung eines induktivitätsabhängigen Messsignals L_{M} besteht darin, eine bekannte Wechselspannung an die Messinduktivität L anzulegen und den dadurch erzeugten Wechselstrom als induktivitätsabhängiges Messsignal L_{M} auszuwerten. Über die aus der Amplitude und Phasenlage des gemessenen Wechselstroms bestimmten Reaktanz wird als Vergleichswert mit dem Fehlerschwellwert verglichen. Ist der Vergleichswert kleiner als der Fehlerschwellwert liegt ein Nicht-Fehlerzustand des Übertragungsweges 4, also kein Leitungsbruch vor, während bei einem Vergleichswert, welcher größer als der Fehlerschwellwert ist, ein Fehlerzustand, also bspw. ein Leitungsbruch einer der beiden elektrischen Verbindungsleitungen L1 oder L2 des Übertragungsweges 4 vorliegt.

Die Diagnosevorrichtung 5 weist somit die Eigenschaft auf, dass in Abhängigkeit des ausgewerteten induktivitätsabhängigen Messsignals L_{M} der Zustand des Übertragungsweges 4 angezeigt wird, ob also ein Leitungsbruch vorliegt oder nicht vorliegt, d. h. entweder ist "Redundanz vorhanden" oder "Redundanz nicht vorhanden".

Ein anderes Verfahren zur Erzeugung des induktivitätsabhängigen Messsignals L_{M} besteht darin, das Dämpfungsverhalten eines mit der Sekundärwicklung W2 aufgebauten Tief- oder Hochpasses zu bestimmen. Aus dem das Dämpfungsverhalten anzeigenden induktivitätsabhängigen Messsignal L_{M} wird ein Dämpfungswert als Vergleichswert ermittelt und mit einem entsprechend geeigneten Fehlerschwellwert verglichen.

Bei einem Dämpfungswert, welcher kleiner als der Fehlerschwellwert ist, zeigt das induktivitätsabhängige Messsignal L_{M} eine niedrige Induktivität der Messinduktivität L an, d. h. es liegt eine Nicht-Fehlerzustand, also kein Defekt, bspw. ein Leitungsbruch des Übertragungsweges 4 vor. Im anderen Fall, bei einem über dem Fehlerschwellwert liegenden Dämpfungswert wird mit dem induktivitätsabhängigen Messsignal eine hohe Induktivität angezeigt, d. h. es liegt ein Fehlerzustand, also ein Defekt, bspw. ein Leitungsbuch des Übertragungsweges 4 vor.

Ein weiteres Verfahren zur Erzeugung des induktivitätsabhängigen Messsignals L_{M} besteht darin, mit der Messinduktivität L einen LC-Resonanzkreis aufzubauen, so dass dessen Resonanzverhalten mit dem induktivitätsabhängigen Messsignal L_{M} angezeigt wird und hieraus als Vergleichswert die Resonanzfrequenz ermittelt wird, um mit einem entsprechend geeigneten Fehlerschwellwert verglichen zu werden.

Schließlich können auch mittels des induktivitätsabhängigen Messsignals L_{M} Signalverformungen eines an die Messinduktivität L angelegten Steuersignals mit mehreren Frequenzkomponenten erfasst und ausgewertet werden. Insbesondere kann hierzu der Zeitverlauf beim Ein- und/oder Ausschalten der Sekundärwicklung erfasst und hinsichtlich der Einschwingvorgänge und/oder der Ausschwingvorgänge ausgewertet werden.

Dieses Verfahren kann bspw. derart umgesetzt werden, dass ein als Rechtecksignal ausgebildetes Steuersignal an die Messinduktivität L angelegt wird. Der von dem Steuersignal erzeugte Flankenverlauf wird als induktivitätsabhängigs Messsignal L_{M} erfasst und der Verzerrungsgrad des Flankenverlaufs des Steuersignals ausgewertet, da dieser Verzerrungsgrad von der Induktivität L_{M} der Messinduktivität L und damit vom Zustand der beiden elektrischen Verbindungsleitungen L1 und L2 abhängt. Der Verzerrungsgrad wird als Vergleichswert mit einem passenden Fehlerschwellwert verglichen.

Bei einem Verzerrungsgrad, welcher kleiner als der Fehlerschwellwert ist, zeigt das induktivitätsabhängige Messsignal L_{M} eine niedrige Induktivität der Messinduktivität L an, d. h. es liegt eine Nicht-Fehlerzustand, also kein Defekt, bspw. ein Leitungsbruch des Übertragungsweges 4 vor. Im anderen Fall, bei einem über dem Fehlerschwellwert liegenden Verzerrungsgrad wird mit dem induktivitätsabhängigen Messsignal eine hohe Induktivität angezeigt, d. h. es liegt ein Fehlerzustand, also ein Defekt, bspw. ein Leitungsbuch des Übertragungsweges 4 vor.

In Abhängigkeit des ermittelten Verzerrungsgrades des Steuersignals wird der Zustand der beiden elektrischen Verbindungsleitungen L1 und L2 angezeigt, ob also ein Leitungsbruch vorliegt oder nicht vorliegt , d. h. entweder ist "Redundanz vorhanden" oder "Redundanz nicht vorhanden".

Die Figur 2 zeigt eine elektrische Anordnung 1 gemäß Figur 1, jedoch ohne die beiden elektrischen Vorrichtungen 2 und 3, wobei der von dem Magnetkern MK zusammen mit dem Primärleiter P und der Sekundärwicklung W2 gebildete Transformator einen detaillierten Aufbau zeigt. Die Signal- oder Leistungsrichtung des redundanten elektrischen Übertragungsweges 4 ist mit dem Bezugszeichen R angegeben.

Gemäß Figur 2 ist der Magnetkern MK als Ringkern ausgeführt und umschließt die Leitung L2 des redundanten elektrischen Übertragungsweges 4. Damit besteht der Primärleiter P lediglich aus einer halben Wicklungsschleife W1, die somit ein gerades Stück der elektrischen Verbindungsleitung L1 darstellt. Die auf dem als Ringkern ausgeführten Magnetkern MK angeordnete Sekundärwicklung W2 besteht aus einer gegenüber der Windungszahl N1 des Primärleiters P größeren Windungszahl N2 (bspw. 10 Windungen).

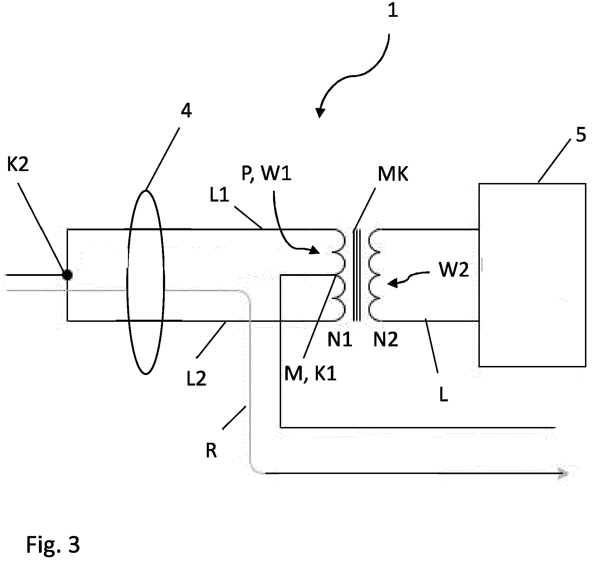

Auch die Figur 3 zeigt eine elektrische Anordnung gemäß Figur 1, jedoch ohne die beiden elektrischen Vorrichtungen 2 und 3. Auch in dieser Figur 3 ist die Signal- oder Leistungsrichtung des redundanten elektrischen Übertragungsweges 4 mit dem Bezugszeichen R angegeben.

Die Mittel zur Erkennung eines Fehlerzustandes oder eines Nicht-Fehlerzustandes umfassen bei dieser elektrischen Anordnung 1 gemäß Figur 3 ebenso einen Magnetkern MK mit einem Primärleiter P mit mehreren Wicklungsschleifen W1 und einer Sekundärwicklung W2 mit einer Windungszahl N2, die größer ist als die Windungszahl N1 des Primärleiter P, sowie eine Diagnosevorrichtung 5.

Der Unterschied der elektrischen Anordnung 1 nach Figur 3 zu derjenigen nach Figur 1 besteht darin, dass die beiden elektrischen Verbindungsleitungen L1 und L2 endseitig jeweils mit einem Wicklungsende der Wicklungsschleifen W1 verbunden sind und eine Mittelanzapfung M den Knotenpunkt K1 bildet, welcher elektrisch mit einer nicht dargestellten zweiten elektrischen Vorrichtung verbunden ist. Der Knotenpunkt K1 ist entsprechend der elektrischen Anordnung 1 nach Figur 1 mit einer ersten elektrischen Vorrichtung verbunden.

### Bezugszeichenliste

- 1: Elektrische Anordnung
- 2: erste elektrische Vorrichtung
- 3: zweite elektrische Vorrichtung
- 4: redundanter elektrischer Übertragungsweg
- 5: Diagnosevorrichtung

- K1: Knotenpunkt
- K2: Knotenpunkt

- L1: elektrische Verbindungsleitung
- L2: elektrische Verbindungsleitung

- MK: Magnetkern

- N1: Anzahl der Wicklungsschleifen W1
- N2: Windungszahl der Sekundärwicklung W2

- M: Mittelanzapfung der Wicklungsschleife W1

- P: Primärleiter

- R: Signal- oder Leistungsrichtung

- W1: Wicklungsschleife des Primärleiters P
- W2: Sekundärwicklung

## Patentansprüche

1. Elektrische Anordnung (1) mit
- einer ersten elektrischen Vorrichtung (2),
- einer zweiten elektrischen Vorrichtung (3),
- einem redundanten elektrischen Übertragungsweg (4) mit zwei parallel geschalteten elektrischen Verbindungsleitungen (L1, L2) zwischen der ersten elektrischen Vorrichtung (2) und der zweiten elektrischen Vorrichtung (3), **gekennzeichnet durch** folgende Merkmale:
- Mitteln (MK, W1, W2, 5) zur Erkennung eines Fehlerzustandes des redundanten elektrischen Übertragungsweges (4), umfassend
- einen Magnetkern (MK) mit einem niederohmigen Primärleiter (P) im Bereich von 100 mΩ oder darunter mit wenigstens einer halben Wicklungsschleife (W1) bis zu drei Wicklungsschleifen (W1), wobei der Primärleiter (P) nur von einer der beiden Verbindungsleitungen (L1, L2) gebildet ist, sowie mit einer Sekundärwicklung (W2) mit einer Windungszahl (N2) größer als die Anzahl (N1) der Wicklungsschleifen (W1) des Primärleiters (P), wobei die Sekundärwicklung (W2) über den Magnetkern (MK) mit dem Primärleiter (P) induktiv stark gekoppelt ist und
- eine Diagnosevorrichtung (5) zur Auswertung eines induktivitätsabhängigen Messsignals der Sekundärwicklung (W2), wobei
- die Diagnosevorrichtung (5) ausgebildet ist, die induktivitätsabhängigen Messsignale (L_{M}) der Sekundärwicklung (W2) mit einem zur Unterscheidung zwischen dem Fehlerzustand und einem Nicht-Fehlerzustand des redundanten elektrischen Übertragungsweges (4) verwendbaren Vergleichswert, insbesondere einen Fehlerschwellwert, zu vergleichen.

2. Elektrische Anordnung (1)nach Anspruch 1, bei welcher der Primärleiter (P) niederohmiger als die Sekundärwicklung (W2) ausgebildet ist.

3. Elektrische Anordnung (1) nach Anspruch 1 oder 2, bei welcher die Verbindungsleitungen (L1, L2) als Versorgungsleitungen zur Energieversorgung ausgebildet sind.

4. Elektrische Anordnung (1) nach einem der Ansprüche 1 bis 3, bei welcher die Verbindungsleitungen (L1,L2) als Signalleitungen ausgebildet sind

5. Elektrische Anordnung nach einem der Ansprüche 1 bis 4, bei welcher der Vergleichswert eine Maß für die zeitliche Veränderung des Messsingales ist.

6. Verfahren zur Erkennung eines Fehlerzustandes eines redundanten elektrischen Übertragungsweges (4) mit einer elektrischen Anordnung nach einem der Ansprüche 1 bis 5 umfassend die Verfahrensschritte:
- Erzeugen eines induktivitätsabhängigen Messsignals (L_{M}) der Messinduktivität (L),
- Auswerten des induktivitätsabhängigen Messsignals (L_{M}) zur Unterscheidung eines Fehlerzustandes von einem Nicht-Fehlerzustand des redundanten elektrischen Übertragungsweges (4), indem das induktivitätsabhängige Messsignal (L_{M}) der Messinduktivität (L) mit einem zur Unterscheidung zwischen einem Fehlerzustand und einem Nicht-Fehlerzustand des redundanten elektrischen Übertragungsweges (4) verwendbaren Vergleichswert, insbesondere einen Fehlerschwellwert verglichen wird,
- Anzeigen, dass ein Nicht-Fehlerzustand vorliegt, wenn das induktivitätsabhängige Messsignal (L_{M}) (L_{M}) kleiner als der Vergleichswert ist, und
- Anzeigen, dass bei einer der Verbindungsleitungen (L1, L2) ein Fehlerzustand vorliegt, wenn das induktivitätsabhängige Messsignal (L_{M}) (L_{I1}) größer als der Vergleichswert ist.

7. Verfahren nach Anspruch 6, bei welchem als induktivitäts-
abhängiges Messsignal (L_{M}) ein Dämpfungswert eines mittels der Sekundärwicklung (W2) gebildeten RL-Tiefpassfilters oder RL-Hochpassfilters oder LC-Filters ermittelt wird.

8. Verfahren nach Anspruch 6, bei welchem als induktivitäts-
abhängiges Messsignal (L_{M}) eine Resonanzfrequenz eines mittels der Sekundärwicklung (W2) gebildeten Resonanzkreises ermittelt wird.

9. Verfahren nach Anspruch 6, bei welchem als induktivitäts-
abhängige Messsignale (L_{M}) die Signalverformung eines an die Sekundärwicklung (W2) angelegten Steuersignals mit mehreren Frequenzkomponenten ermittelt wird.

## Claims

1. Electrical arrangement (1) comprising
- a first electrical device (2),
- a second electrical device (3),
- a redundant electrical transmission path (4) comprising two electrical connection lines (L1, L2), connected in parallel, between the first electrical device (2) and the second electrical device (3),
**characterised by** the following features:
- means (MK, W1, W2, 5) for detecting an error state of the redundant electrical transmission path (4), comprising
- a magnet core (MK) having a low-ohmic primary conductor (P) in the region of 100 mΩ or less having at least half a winding loop (W1) up to three winding loops (W1), wherein the primary conductor (P) is formed only by one of the two connection lines (L1, L2), and having a secondary winding (W2) having a winding number (N2) greater than the number (N1) of the winding loops (W1) of the primary conductor (P), wherein the secondary winding (W2) is strongly inductively coupled to the primary conductor (P) via the magnet core (MK), and
- a diagnosis device (5) for evaluating an inductance-dependent measuring signal of the secondary winding (W2), wherein
- the diagnosis device (5) is configured to compare the inductance-dependent measuring signals (L_{M}) of the secondary winding (W2) with a comparative value, in particular an error threshold value, that can be used for distinguishing between the error state and a non-error state of the redundant electrical transmission path (4).

2. Electrical arrangement (1) according to claim 1, in which the primary conductor (P) is configured to be lower-ohmic than the secondary winding (W2).

3. Electrical arrangement (1) according to either claim 1 or claim 2, in which the connection lines (L1, L2) are configured as supply lines for energy supply.

4. Electrical arrangement (1) according to any of claims 1 to 3, in which the connection lines (L1, L2) are configured as signal lines.

5. Electrical arrangement (1) according to any of claims 1 to 4, in which the comparative value is a measure for the temporal change in the measuring signal.

6. Method for detecting an error state of a redundant electrical transmission path (4) comprising an electrical arrangement according to any of claims 1 to 5, comprising the method steps of:
- generating an inductance-dependent measuring signal (L_{M}) of the measuring inductance (L),
- evaluating the inductance-dependent measuring signal (L_{M}) for distinguishing an error state from a non-error state of the redundant electrical transmission path (4), in that the inductance-dependent measuring signal (L_{M}) of the measuring inductance (L) is compared with a comparative value, in particular an error threshold value, that can be used for distinguishing between the error state and a non-error state of the redundant electrical transmission path (4),
- indicating that a non-error state is present if the inductance-dependent measuring signal (L_{M}) (L_{M}) is smaller than the comparative value, and
- indicating that there is an error state in one of the connection lines (L1, L2) if the inductance-dependent measuring signal (L_{M}) (L_{M}) is greater than the comparative value.

7. Method according to claim 6, in which a damping value of an RL low-pass filter or RL high-pass filter or LC filter formed by means of the secondary winding (W2) is determined as the inductance-dependent measuring signal (L_{M}).

8. Method according to claim 6, in which a resonant frequency of a resonant circuit formed by means of the secondary winding (W2) is determined as the inductance-dependent measuring signal (L_{M}).

9. Method according to claim 6, in which the signal deformation of a control signal applied to the secondary winding (W2), having a plurality of frequency components, is determined as the inductance-dependent measuring signals (L_{M}).

## Revendications

1. Agencement (1) électrique comprenant
- un premier dispositif (2) électrique,
- un deuxième dispositif (3) électrique,
- un chemin (4) de transmission électrique redondant ayant deux lignes (L1, L2) de connexion électrique montées en parallèle entre le premier dispositif (2) électrique et le deuxième dispositif (3) électrique, **caractérisé par** les caractéristiques suivantes :
- des moyens (MK, W1, W2, 5) d'identification d'un état de défaut du chemin (4) de transmission électrique redondant, comprenant
- un noyau (MK) magnétique ayant un conducteur (P) primaire à petite valeur ohmique de l'ordre de 100 mΩ ou moins comprenant d'au moins une demi-boucle (W1) d'enroulement à trois boucles (W1) d'enroulement, dans lequel le conducteur (P) primaire n'est formé que par l'une des lignes (L1, L2) de connexion, ainsi que comprenant un enroulement (W2) secondaire ayant un nombre (N2) de spires plus grand que le nombre (N1) des boucles (W1) d'enroulement du conducteur (P) primaire, dans lequel l'enroulement (W2) secondaire est couplé fortement inductivement au conducteur (P) primaire par le noyau (MK) magnétique et
- un dispositif (5) de diagnostic pour l'évaluation d'un signal de mesure, qui dépend de l'inductance, de l'enroulement (W2) secondaire, dans lequel
- le dispositif (5) de diagnostic est constitué pour comparer les signaux (L_{M}) de mesure, qui dépendent de l'inductance, de l'enroulement (W2) secondaire à une valeur de comparaison, en particulier à une valeur de seuil de défaut, pour distinguer entre l'état de défaut et un état de non défaut du chemin (4) de transmission électrique redondant.

2. Agencement (1) électrique suivant la revendication 1, dans lequel le conducteur (P) primaire est à plus petite valeur ohmique que l'enroulement (W2) secondaire.

3. Agencement (1) électrique suivant la revendication 1 ou 2, dans lequel les lignes (L1, L2) de connexion sont constituées en lignes d'alimentation pour l'alimentation en énergie électrique.

4. Agencement (1) électrique suivant l'une des revendications 1 à 3, dans lequel les lignes (L1, L2) de connexion sont constituées en lignes de signalisation.

5. Agencement électrique suivant l'une des revendications 1 à 4, dans lequel la valeur de comparaison est une mesure de la variation dans le temps du signal de mesure.

6. Procédé d'identification d'un état de défaut d'un chemin (4) de transmission électrique redondant comprenant un agencement électrique suivant l'une des revendications 1 à 5, comprenant les stades du procédé :
- production d'un signal (L_{M}) de mesure, qui dépend de l'inductance, de l'inductance (L) de mesure,
- évaluation du signal (L_{M}) de mesure, qui dépend de l'inductance, pour distinguer un état de défaut d'un état de non-défaut du chemin (4) de transmission électrique redondant, en comparant le signal (L_{M}) de mesure, qui dépend de l'inductance, de l'inductance (L) de mesure à une valeur de comparaison, en particulier à une valeur de seuil de défaut, pouvant être utilisée pour distinguer entre un état de défaut et un état de non-défaut du chemin (4) de transmission électrique redondant,
- affichage qu'il y a un état de non-défaut, si le signal (L_{M}) de mesure, qui dépend de l'inductance, (L_{M}) est plus petit que la valeur de comparaison et
- affichage qu'il y a un état de défaut dans l'une des lignes (L1, L2) de connexion, si le signal (L_{M}) de mesure, qui dépend de l'inductance, (L_{M}) est plus grand que la valeur de comparaison.

7. Procédé suivant la revendication 6, dans lequel on détermine comme signal (L_{M}) de mesure, qui dépend de l'inductance, une valeur d'amortissement d'un filtre passe bas-RL formé au moyen de l'enroulement (W2) secondaire ou d'un filtre passe haut-RL ou d'un filtre-LC.

8. Procédé suivant la revendication 6, dans lequel on détermine comme signal (L_{M}) de mesure, qui dépend de l'inductance, une fréquence de résonnance d'un circuit résonnant formé au moyen de l'enroulement (W2) secondaire.

9. Procédé suivant la revendication 6, dans lequel on détermine comme signal (L_{M}) de mesure, qui dépend de l'inductance, la déformation d'un signal de commande appliqué à l'enroulement (W2) secondaire et ayant plusieurs composantes de fréquence.
